# FASCICULE DE BREVET EUROPEEN

(11) **EP 0 759 155 B1**
(45) Date de publication et mention de la délivrance du brevet: **08.09.1999**
(21) Numéro de dépôt: 95920138.5
(22) Date de dépôt: 11.05.1995
(51) Int. Cl.: G01L 5/00, G01L 1/24, C23C 14/54

(54) **PROCEDE ET DISPOSITIF POUR LA MESURE IN SITU DES CONTRAINTES SE DEVELOPPANT AU SEIN D'UNE COUCHE MINCE LORS DE SON DEPOT SUR UN SUBSTRAT**
VERFAHREN UND VORRICHTUNG ZUR IN SITU MESSUNG DER DEHNUNG IN EINEM DUNNFILM WAHREND SEINES NIEDERSCHLAGS AUF EINEM SUBSTRAT
METHOD AND DEVICE FOR IN SITU STRESS MEASUREMENT WITHIN A THIN FILM UPON ITS DEPOSITION ON A SUBSTRATE

(30) Priorité: 11.05.1994 FR 9405793
(43) Date de publication de la demande: 26.02.1997
(73) Titulaire: ESSILOR INTERNATIONAL (Compagnie Générale d'Optique), F-94220 Charenton-le-Pont (FR)
(72) Inventeur: FRAKSO, Fatima, F-49130 Les-Ponts-de-Cé (FR); BOSMANS, Richard, F-94880 Noiseau (FR); NOUVELOT, Luc, F-38120 Saint-Egrève (FR)
(74) Mandataire: CABINET BONNET-THIRION
(86) Numéro de dépôt international: FR9500619
(87) Numéro de publication internationale: WO9531706

(56) Documents cités:
- FR-A- 2 344 643
- US-A- 3 570 449
- IBM TECHNICAL DISCLOSURE BULLETIN., vol. 26, no. 7B, Décembre 1983 NEW YORK US, pages 3879-3882, J.M.E. HARPER ET AL. 'STRESS MEASUREMENT DEVICE'
- PATENT ABSTRACTS OF JAPAN vol. 10 no. 97 (P-446) [2154] ,15 Avril 1986 & JP,A,60 229255 (MATSUSHITA DENKI SANGYO K.K.) 14 Novembre 1985,
- APPLIED PHYSICS LETTERS, vol. 63, no. 25, 20 Décembre 1993 NEW YORK US, pages 3437-3439, XP 000416557 C.M. SU ET AL. 'IN SITU MECHANICAL RELAXATION OF CU FILMS GROWING ON A SI SUBSTRATE'
- JOURNAL OF VACUUM SCIENCE AND TECHNOLOGY: PART A, vol. 4, no. 3, Mai 1986 NEW YORK US, pages 645-649, Y.S. CHEN ET AL. 'STRESS MEASUREMENTS ON MULTILEVEL THIN FILM DIELECTRIC LAYERS USED IN SI INTEGRATED CIRCUITS'
- IBM TECHNICAL DISCLOSURE BULLETIN., vol. 4, no. 7, Décembre 1961 NEW YORK US, page 63 H.L. CASWELL ET AL. 'RESIDUAL STRESS MEASURING INSTRUMENT'
- PATENT ABSTRACTS OF JAPAN vol. 12 no. 426 (C-542) [3273] ,10 Novembre 1988 & JP,A,63 157869 (MITSUBISHI ELECTRIC CORP) 30 Juin 1988,

## Description

La présente invention concerne d'une manière générale la mesure des contraintes se développant au sein d'une couche mince lors de son dépôt sur un substrat, en vue d'un contrôle de ces contraintes.

Elle vise plus particulièrement, mais non nécessairement exclusivement, le cas où ce substrat est un verre de lunettes, ou, plus précisément, le palet de contour périphérique globalement circulaire dont peut ultérieurement être issu par débordage un tel verre de lunettes.

Ainsi qu'on le sait, il est usuel de rapporter une couche mince sur l'une et l'autre des faces d'un verre de lunettes, par exemple pour lui conférer des propriétés antireflet de nature à le rendre plus discret et/ou pour en améliorer la résistance à la rayure ou à l'abrasion, notamment lorsqu'il s'agit d'un verre de lunettes en matière organique.

Le dépôt de cette couche mince se fait usuellement sous vide, par exemple par évaporation, obtenue par bombardement électronique, dans une enceinte de traitement appropriée, dans laquelle intervient en pratique un support collectif, par exemple en forme générale de cloche, présentant une pluralité d'emplacements propres à recevoir chacun individuellement les verres de lunettes à traiter.

Il s'avère que toute couche mince ainsi déposée sur un substrat est l'objet de contraintes internes qui se sont développées lors même de son dépôt sur ce substrat, et qui, tendant à la dilater ou à la comprimer par rapport à celui-ci, sont de nature à conduire à son arrachement ou à faciliter celui-ci lors d'éventuelles agressions externes si les forces d'adhérence qui tendent conjointement à la maintenir sur ce substrat ne sont pas suffisantes.

Ces contraintes internes sont à la fois de nature thermique, en résultant d'une inévitable différence entre les coefficients de dilatation thermique des matériaux en cause pendant les phases de chauffage et de refroidissement inhérentes au traitement mis en oeuvre, et à la fois de nature intrinsèque, en résultant d'un réarrangement structurel des atomes intervenant inévitablement lors même de la formation de la couche.

Pour pouvoir contrôler ces contraintes internes, et ainsi améliorer la bonne tenue de la couche mince déposée, il est d'abord nécessaire de les mesurer.

Dans le brevet américain No 5 154 810, il est proposé de mettre en oeuvre pour ce faire un échantillon d'essai, qui est porté par le support collectif sur lequel sont disposés les substrats à traiter, une source de lumière, qui dirige un faisceau lumineux sur cet échantillon d'essai, et un détecteur, en l'espèce un détecteur optique, et, plus précisément, un détecteur de déplacement, sur lequel est renvoyé le faisceau lumineux réfléchi par celui-ci.

Au fur et à mesure que se dépose une couche mince sur l'échantillon d'essai, les contraintes se développant dans cette couche mince conduisent à une courbure de cet échantillon d'essai dont il résulte une déviation du faisceau lumineux réfléchi.

Mesurée par le détecteur de déplacement, cette déviation permet d'apprécier la courbure de l'échantillon d'essai, et, partant, les contraintes internes de la couche mince qu'il porte.

Outre sa relative simplicité, un tel procédé a notamment pour avantage de permettre d'intervenir in situ, l'échantillon d'essai étant disposé au sein même de l'enceinte de traitement.

Dans le brevet américain No 5 154 810, cependant, la source de lumière mise en oeuvre est disposée à l'extérieur de l'enceinte de traitement, et il en est de même du détecteur de déplacement.

Il en résulte que tant le faisceau lumineux incident que le faisceau lumineux réfléchi doivent traverser un hublot, qui, en raison du dépôt dont il est inévitablement lui-même l'objet, devient de moins en moins transparent au fur et à mesure de l'avancement du traitement, ce qui nuit rapidement à la qualité de la mesure conjointement effectuée.

En outre, l'échantillon d'essai étant placé sur un support collectif en mouvement, la mesure n'est possible que lorsque cet échantillon d'essai se trouve en face du hublot servant au passage des faisceaux lumineux de mesure.

De ce fait, la mesure est discontinue, et, forcément, comparative.

Elle fait de plus intervenir des témoins disposés en amont et en aval de l'échantillon d'essai.

Chaque mesure nécessite donc trois opérations, l'une sur l'échantillon d'essai, les autres sur les témoins, et il faut synchroniser ces opérations avec le mouvement du support collectif, ce qui complique de manière non négligeable l'ensemble.

La présente invention a d'une manière générale pour objet un procédé et un dispositif permettant d'éviter ces inconvénients et présentant en outre d'autres avantages.

Suivant l'invention, pour la mesure in situ des contraintes se développant au sein d'une couche mince lors de son dépôt sur un substrat dans une enceinte de traitement dans laquelle intervient un support collectif présentant une pluralité d'emplacements propres à recevoir chacun un tel substrat, avec mise en oeuvre, d'une part, d'un échantillon d'essai qui est porté par le support collectif, et, d'autre part, d'un détecteur qui est destiné à mesurer la déformation dont est l'objet cet échantillon d'essai, on dispose l'échantillon d'essai sur un support individuel, qui est susceptible d'être reçu dans un des emplacements du support collectif en substitution à un substrat, et qui porte, en outre, conjointement, la portion introductive, au moins, du détecteur.

Lorsque, par exemple, le détecteur est un détecteur optique, le faisceau lumineux réfléchi dans sa direction par l'échantillon d'essai se développe exclusivement à l'intérieur même de l'enceinte de traitement, et il est donc avantageusement épargné de toute traversée de hublot.

D'une manière plus générale, il en est avantageusement de même pour toute transmission de donnée(s) entre l'échantillon d'essai et la portion introductive du détecteur, quelle que soit la nature, optique, électrique ou mécanique, de celui-ci.

De plus, le support individuel portant l'échantillon d'essai portant également la partie introductive, au moins, du détecteur, cette partie introductive du détecteur est fixe par rapport à l'échantillon d'essai, et la mesure peut donc être effectuée en continu, sans être comparative.

L'acquisition du résultat de ces mesures s'en trouve avantageusement simplifiée.

Par ailleurs, le support individuel mis en oeuvre suivant l'invention est avantageusement transposable d'une enceinte de traitement à une autre à la manière d'un quelconque système embarqué, ce qui en facilite la mise en oeuvre.

En outre, il est avantageusement susceptible d'une réalisation plus ou moins massive et compacte, ce qui le rend peu sensible aux vibrations inhérentes aux enceintes de traitement, au bénéfice de la précision et de la qualité des mesures effectuées.

Ce support individuel est en outre avantageusement compatible avec le vide, stable en température et dans le temps, et non destructif.

En bref, l'invention permet avantageusement de suivre avec une très bonne sensibilité l'évolution des contraintes internes de la couche mince à contrôler, dès les premières phases de croissance de celle-ci.

Les caractéristiques et avantages de l'invention ressortiront d'ailleurs de la description qui va suivre, à titre d'exemple, en référence aux dessins schématiques annexés sur lesquels :
la figure 1 est, à échelle relativement réduite, une vue en perspective du support collectif devant porter les substrats à traiter ;
la figure 2 est, à échelle supérieure, et suivant la ligne II-II de la figure 1, une vue en coupe axiale du support individuel substitué suivant l'invention à l'un de ces substrats pour porter un échantillon d'essai ;
les figures 3, 4 et 5 sont des vues en coupe axiale qui, analogues à celle de la figure 2, se rapportent chacune respectivemènt à diverses variantes de mise en oeuvre de l'invention ;
la figure 6 est une vue en coupe axiale analogue à celle de la figure 2, pour une autre variante de réalisation ;
la figure 7 est une vue schématique en perspective analogue à celle de la figure 1, pour une variante de réalisation des moyens de transmission permettant l'exploitation des signaux de mesure relevés.

Ces figures illustrent, à titre d'exemple, l'application de l'invention à des substrats 10 formés de palets à déborder pour constituer ensuite des verres de lunettes.

Il s'agit, globalement, d'assurer le dépôt d'une quelconque couche mince, et, par exemple, d'une couche antireflet, sur ces substrats 10.

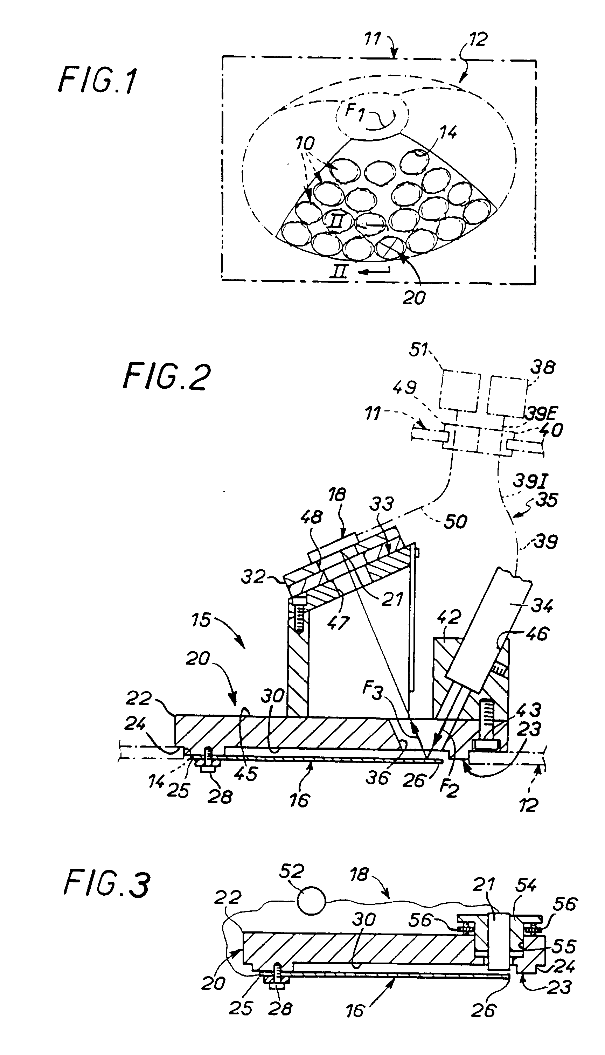

Tel que schématisé sur la figure 1, il est mis en oeuvre, à cet effet, dans une enceinte de traitement 11, un support collectif 12, qui, pour des raisons pratiques, est en forme générale de calotte sphérique dans la forme de mise en oeuvre illustrée, et qui, monté rotatif dans l'enceinte de traitement 11, par exemple suivant la flèche F1 de la figure 1, présente une pluralité d'emplacements 14, en pratique de simples ouvertures de contour circulaire, propres à recevoir chacun un substrat 10.

Les dispositions correspondantes étant bien connues par elles-mêmes, notamment par le brevet américain No 4 817 559 et par la demande de brevet français qui, déposée le 22 janvier 1991 sous le No 91 00665, a été publiée sous le No 2 671 738, elles ne seront pas décrites plus en détail ici.

De manière également connue en soi, notamment par le brevet américain No 5 154 810, il est conjointement prévu, pour la mesure in situ des contraintes se développant au sein de la couche mince déposée sur les substrats 10 lors même de son dépôt sur ceux-ci, un dispositif 15, qui, globalement, met en oeuvre un échantillon d'essai 16, qui est porté par le support collectif 12, et un détecteur 18, qui est destiné à mesurer la déformation dont est l'objet cet échantillon d'essai 16.

Suivant l'invention, l'échantillon d'essai 16 est porté par un support individuel 20, qui est susceptible d'être reçu dans un des emplacements 14 du support collectif 12, en substitution à un substrat 10, et qui porte, en outre, conjointement, la portion introductive 21, au moins, du détecteur 18.

Dans les formes de réalisation représentées sur les figures 2 à 4, le support individuel 20 comporte une semelle 22, qui, par elle-même, forme un bloc relativement massif, et en pratique métallique, et qui, de contour circulaire, présente, annulairement, à la périphérie de sa surface inférieure 23, qui forme la surface inférieure du support individuel 20, une feuillure 24, pour son emboîtement dans un des emplacements 14 du support collectif 12.

Conjointement, dans ces formes de réalisation, l'échantillon d'essai 16 intervient du côté de la surface inférieure 23 du support individuel 20, et il s'agit d'une lame qui est portée par le support individuel 20 en étant encastrée à l'une, 25, de ses extrémités, et libre, à l'autre, 26, de celles-ci.

Par exemple, cette lame a, en plan, un contour globalement quadrangulaire.

Dans les formes de réalisation représentées, elle est rapportée par une ou plusieurs vis 28 sur la surface inférieure 23 du support individuel 20 à son extrémité encastrée 25, et, au repos, tel que représenté, elle s'étend sensiblement parallèlement à cette surface inférieure 23, à la faveur d'un dégagement 30 prévu en correspondance sur celle-ci.

Dans la forme de réalisation plus particulièrement représentée sur la figure 2, le détecteur 18 est un détecteur optique, et il s'agit par exemple d'un détecteur de déplacement de type PSD ("position sensitive detector").

La portion introductive 21, au moins, de ce détecteur 18, est portée par le support individuel 20 par l'intermédiaire d'une platine 32 formant une table XY.

En pratique, dans la forme de réalisation représentée, le détecteur 18 est tout entier situé à l'intérieur de l'enceinte de traitement 11, et il est donc en totalité porté par le support individuel 20, par l'intermédiaire de la platine 32 formant une table XY.

En pratique, cette platine 32 est elle-même portée par un pupitre 33 qui, solidaire de la semelle 22, est incliné d'un certain angle par rapport à celle-ci.

Le support individuel 20 porte également la portion terminale 34, au moins, d'une source de lumière 35, qui, tel que schématisé par une flèche F2 sur la figure 2, dirige un faisceau lumineux sur l'extrémité libre 26 de la lame formant l'échantillon d'essai 16, à la faveur d'un évidement 36 de la semelle 22 du support individuel 20.

Dans la forme de réalisation plus particulièrement représentée sur la figure 2, la source de lumière 35 comporte une partie d'émission 38 qui est située à l'extérieur de l'enceinte de traitement 11.

La portion terminale 34 de la source de lumière 35 portée par le support individuel 20 est dès lors formée par l'extrémité d'une partie de conduction 39 reliant à ce support individuel 20 la partie d'émission 38, tel que schématisé en traits interrompus sur la figure 2.

Par exemple, la partie d'émission 38 est un laser au néon, et la partie de conduction 39 est formée de deux tronçons 39E, 39I successifs d'une fibre optique, qui, l'un à l'extérieur de l'enceinte de traitement 11, l'autre à l'intérieur de celle-ci, sont dûment aboutés l'un à l'autre par une traversée étanche 40 permettant de passer à étanchéité de l'extérieur de cette enceinte de traitement 11 à l'intérieur de celle-ci.

Compte tenu de la rotation du support collectif 12, la traversée étanche 40 est préférentiellement établie suivant l'axe de rotation correspondant.

Les modalités constructives de cette traversée étanche 40 ne relevant pas de la présente invention, elles ne seront pas décrites plus complètement ici.

Dans les formes de réalisation représentées, la portion terminale 34 de la source de lumière 35 est portée par un bloc 42 lui-même rapporté, par exemple par une ou plusieurs vis 43, sur la semelle 22 du support individuel 20, à la surface supérieure 45 de celle-ci.

En pratique, cette portion terminale 34 est engagée dans un alésage 46 du bloc 42 qui est incliné sur la semelle 22 d'un angle complémentaire de celui suivant lequel le pupitre 33 portant le détecteur 18 est lui-même incliné sur cette semelle 22.

Ainsi, le faisceau lumineux réfléchi par l'extrémité libre 26 de la lame constituant l'échantillon d'essai 16 est renvoyé sur la portion introductive 21 du détecteur 18, suivant la flèche F3 de la figure 2, à la faveur de l'évidement 36 de la semelle 22.

Pour le passage de ce faisceau lumineux réfléchi, le pupitre 33 est ajouré d'un évidement 47, et, de même, la platine 32 formant la table XY est ajourée d'un évidement 48.

Par l'intermédiaire d'une traversée étanche 49, et tel que schématisé en traits interrompus sur la figure 2, des conducteurs électriques 50 relient le détecteur 18 à une unité d'acquisition 51 située à l'extérieur de l'enceinte de traitement 11.

La distribution de courant le long du détecteur 18 permet en pratique de mesurer la position sur celui-ci du spot lumineux induit par le faisceau lumineux réfléchi par la lame constituant l'échantillon d'essai 16.

En pratique, le signal délivré par l'unité d'acquisition 51 est alors proportionnel au déplacement de ce spot.

Or, lié à la déflexion de la lame constituant l'échantillon d'essai 16, ce déplacement est lui-même proportionnel aux contraintes prenant naissance dans la couche mince déposée sur cette lame.

Le signal délivré par l'unité d'acquisition 51 donne donc en pratique directement ces contraintes internes.

Suivant diverses variantes de réalisation non représentées, il est prévu une mobilité relative entre la portion terminale 34, au moins, de la source de lumière 35 et le détecteur 18.

Par exemple, la portion terminale 34 de la source de lumière 35 est montée mobile en translation sur le support individuel 20, de manière à ce que le faisceau lumineux qui en est issu balaye en longueur la lame constituant l'échantillon d'essai 16.

En variante, il est prévu un mouvement combiné de translation et de rotation de cette portion terminale 34.

Dans ce cas, le déplacement correspondant est choisi pour que le point d'impact sur la portion introductive 21 du détecteur 18 du faisceau lumineux réfléchi par la lame constituant l'échantillon d'essai 16 soit toujours dans la même zone.

Par exemple, le déplacement de la portion terminale 34 de la source de lumière 35 peut se faire le long d'un rail circulaire.

En variante, cette portion terminale 34 peut être disposée en bout d'un bras monté rotatif.

Dans la variante de réalisation représentée sur la figure 3, le détecteur 18 est un détecteur électrique.

En pratique, sa portion introductive 21 est une électrode formant avec l'échantillon d'essai 16 une capacité différentielle, et il comporte en outre un capacimètre 52 établi entre cette électrode et l'échantillon d'essai 16.

Sous l'effet du dépôt, la lame constituant l'échantillon d'essai 16 se courbe et provoque une légère variation de l'espace qui la sépare de l'électrode associée.

Il en résulte une variation de la capacité correspondante, qui, mesurée par le capacimètre 52, est fonction de la déflexion de la lame constituant l'échantillon d'essai 16, et, donc, des contraintes au sein de la couche mince déposée sur celle-ci.

Préférentiellement, l'électrode formant la portion introductive 21 du détecteur 18 est montée réglable en position sur le support individuel 20, pour ajustement de la distance la séparant initialement de l'échantillon d'essai 16.

En pratique, dans la forme de réalisation représentée, le support individuel 20 se réduit à sa semelle 22, et l'électrode formant la portion introductive 21 du détecteur 18 est portée par un bloc 54 engagé à coulissement dans un perçage 55 de cette semelle 22, perpendiculairement à la surface inférieure 23 de celle-ci, avec, intervenant entre ce bloc 54 et cette semelle 22, des vérins à vis 56.

Dans la forme de réalisation représentée sur la figure 3, le détecteur 18 constitue en quelque sorte un détecteur de proximité.

Suivant une forme de réalisation non représentée, un tel détecteur de proximité est formé par un détecteur optique comportant un faisceau de fibres dont la portion terminale est disposée au voisinage de l'échantillon d'essai 16, à la manière de l'électrode précédente.

Certaines de ces fibres apportent de la lumière, et la partie de celle-ci réfléchie par l'échantillon d'essai est collectée par les autres.

La mesure des pertes de lumière entre les faisceaux incident et réfléchi correspondants permet de calculer la déformation de l'échantillon d'essai 16.

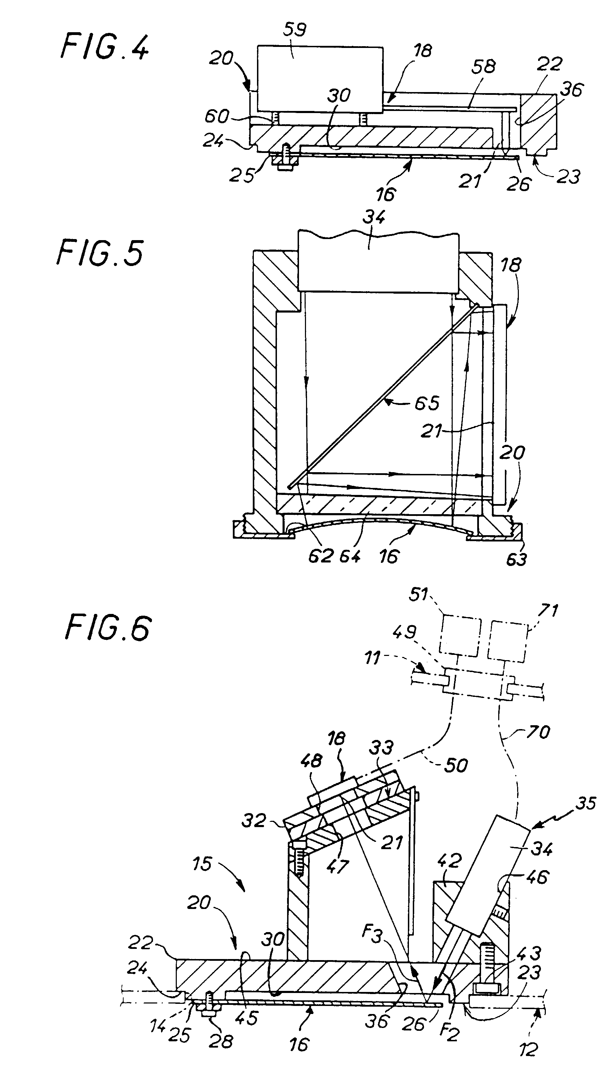

Dans la forme de réalisation représentée sur la figure 4, le détecteur 18 est un détecteur mécanique.

Sa portion introductive 21 est une sonde formant palpeur, qui, sous la sollicitation de moyens élastiques 58, porte sur l'échantillon d'essai 16.

Le détecteur 18 comporte en outre une tête de mesure 59 sensible à la force suivant laquelle la portion introductive 21 s'applique à l'échantillon d'essai 16.

En pratique, dans la forme de réalisation représentée, la portion introductive 21 est disposée en bout d'une lame élastiquement déformable qui, portée par la tête de mesure 59, s'étend librement en porte à faux à compter de celle-ci et constitue par elle-même les moyens élastiques 58 associés.

Comme précédemment, le support individuel 20 se réduit pour l'essentiel à sa semelle 22.

La tête de mesure 59 est montée réglable en position sur cette semelle 22, par l'intermédiaire de vérins à vis 60, qui permettent d'en ajuster la position, et, donc, qui permettent d'ajuster la force suivant laquelle la sonde formant la portion introductive 21 s'applique initialement à l'échantillon d'essai 16, et, plus précisément, à l'extrémité libre 26 de la lame constituant cet échantillon d'essai 16.

Cette sonde suit l'échantillon d'essai 16 au fur et à mesure de sa déformation, et la tête de mesure 59 permet d'apprécier son déplacement, et, donc, la déformation de l'échantillon d'essai 16.

Dans la forme de réalisation représentée sur la figure 5, l'échantillon d'essai 16 est un disque portant par simple gravité à sa périphérie sur un épaulement 62 du support individuel 20.

En pratique, cet épaulement 62 s'étend annulairement, et il appartient à une bague 63 rapportée par vissage sur le support individuel 20.

L'échantillon d'essai 16 est établi en aval d'un disque étalon transparent 64 par rapport à la portion terminale 34 de la source de lumière 35, et sur le faisceau incident, parallèle, correspondant est interposée une lame semi-réfléchissante 65, qui, disposée en oblique, renvoie le faisceau réfléchi vers la portion introductive 21 du détecteur 18.

Une partie de la lumière est réfléchie par le disque étalon transparent 64, et l'autre par l'échantillon d'essai 16.

Les images obtenues ont des dimensions différentes, et la différence entre ces dimensions permet de calculer le rayon de courbure de l'échantillon d'essai 16.

Par exemple, le détecteur 18 peut être une matrice CCD.

En variante, l'échantillon d'essai 16 est, comme précédemment, une lame, et le disque étalon transparent 64 peut alors être placé à côté de cet échantillon d'essai 16, au lieu d'être disposé en amont.

Le faisceau parallèle émis par la portion terminale 34 de la source de lumière 35 peut être remplacé par un faisceau de faible étendue, notamment lorsque cette source de lumière 35 est un laser, ce qui permet de faire balayer la surface de l'échantillon d'essai 16 par ce faisceau lumineux, comme si la portion terminale 34 de cette source de lumière 35 était déplacée en conséquence, mais sans les éventuelles imperfections dues à un tel déplacement.

Dans la variante de réalisation représentée sur la figure 6, qui est en fait une forme de réalisation préférentielle, la source de lumière 35 se réduit à sa portion terminale 34, en étant constituée par une diode laser, qui est directement portée par le bloc 42 du support individuel 20, et qui, par l'intermédiaire de conducteurs électriques 70 traversant la même traversée étanche 49 que les conducteurs électriques 50 reliant le détecteur 18 à l'unité d'acquisition 51, est reliée électriquement à une alimentation électrique 71 située à l'extérieur de l'enceinte de traitement 11.

Cette variante de réalisation présente ainsi l'avantage de ne nécessiter qu'une seule traversée étanche.

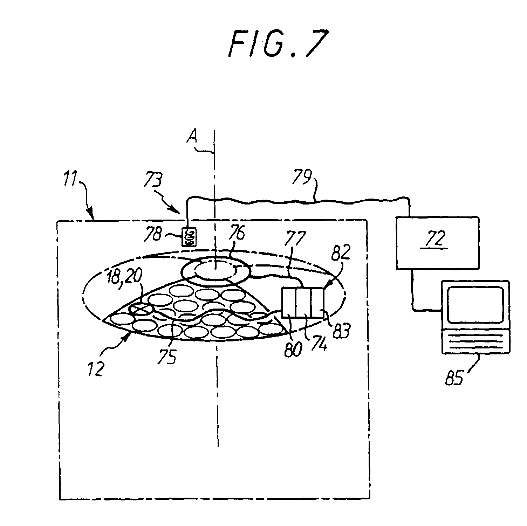

Dans la variante de réalisation schématisée sur la figure 7, le support individuel 20 porte la totalité du détecteur 18, et il est prévu, entre ce détecteur 18 et un récepteur 72 disposé à l'extérieur de l'enceinte de traitement 11, une chaîne de transmission radio 73.

En pratique, cette chaîne de transmission radio 73 comporte, globalement, un émetteur 74, qui est porté par le support collectif 12, et auquel le détecteur 18 est relié par des conducteurs électriques 75, une antenne d'émission 76, qui est elle aussi portée par le support collectif 12, et à laquelle l'émetteur 74 est relié par des conducteurs électriques 77, et une antenne de réception 78, qui est portée par l'enceinte de traitement 11, et qui, par des conducteurs électriques 79 traversant à étanchéité cette enceinte de traitement 11, est reliée au récepteur 72.

En pratique, le support collectif 12 étant monté rotatif dans l'enceinte de traitement 11, autour d'un axe A schématisé en traits interrompus sur la figure 7, l'antenne d'émission 76 est un simple fil électrique s'étendant circulairement autour de cet axe de rotation A, suivant un parallèle du support collectif 12, et l'antenne de réception 78 est disposée à l'aplomb de ce parallèle.

L'antenne de réception 78 est donc en vis-à-vis du cercle décrit par l'antenne d'émission 76 au cours de la rotation du support collectif 12.

La configuration circulaire de cette antenne d'émission 76 permet avantageusement de maintenir constante la distance entre elle et l'antenne de réception 78 pendant la rotation du support collectif 12, ce qui est garant de la qualité de la transmission radio assurée.

L'antenne de réception 78 est par exemple constituée par un simple solénoïde moulé dans un corps en matière synthétique.

Elle n'est en pratique séparée de l'antenne d'émission 76 que par une dizaine de centimètres.

Préférentiellement, il est prévu, en amont de la chaîne de transmission radio 73, entre le détecteur 18 et l'émetteur 74, une unité de traitement 80 apte à convertir en tension le ou les micro-courants en provenance du détecteur 18.

En pratique, cette unité de traitement 80 et l'émetteur 74 sont disposés dans un même boîtier étanche 82, qui est porté par le support collectif 12, et qui contient également les batteries 83 nécessaires à l'alimentation de l'ensemble.

La recharge des batteries 83 peut s'effectuer sans ouverture du boîtier étanche 82, à travers des passages électriques étanches prévus à cet effet dans celui-ci et assurant par ailleurs la traversée des conducteurs électriques 75 et 77.

En fonctionnement, les batteries 83 alimentent le détecteur 18, l'unité de traitement 80 et l'émetteur 74.

Si désiré, et tel que représenté à la figure 7, le récepteur 72 est couplé à un dispositif d'enregistrement 85.

Dans le système de télémesure allant du détecteur 18 au dispositif d'enregistrement 85, la chaîne de transmission radio 73 et le récepteur 72 sont avantageusement transparents.

En effet, l'émetteur 74 reçoit une tension, et, après décodage du signal correspondant, le récepteur 72 délivre cette même tension.

Il s'avère, par ailleurs, que l'ensemble n'est avantageusement pas perturbé par les différentes sources de rayonnement électromagnétiques susceptibles d'être présentes dans l'enceinte de traitement 11, telles que des canons à électron nécessaires à la constitution de sources d'élaboration et/ou des sources d'ions comportant des plasmas.

Bien entendu, la présente invention ne se limite pas aux formes de réalisation décrites et représentées, mais englobe toute variante d'exécution et/ou de combinaison de leurs divers éléments.

## Revendications

1. Procédé pour la mesure in situ des contraintes se développant au sein d'une couche mince lors de son dépôt sur un substrat (10) dans une enceinte de traitement (11) dans laquelle intervient un support collectif (12) présentant une pluralité d'emplacements (14) propres à recevoir chacun un tel substrat (10), procédé suivant lequel il est mis en oeuvre un échantillon d'essai (16), qui est porté par le support collectif (12), et un détecteur (18), qui est destiné à mesurer la déformation dont est l'objet cet échantillon d'essai (16), caractérisé en ce que on dispose l'échantillon d'essai (16) sur un support individuel (20), qui est susceptible d'être reçu dans un des emplacements (14) du support collectif (12) en substitution à un substrat (10), et qui porte, en outre, conjointement, la portion introductive (21), au moins, du détecteur (18).

2. Dispositif pour la mesure in situ des contraintes se développant au sein d'une couche mince lors de son dépôt sur un substrat (10) dans une enceinte de traitement (11) dans laquelle intervient un support collectif (12) présentant une pluralité d'emplacements (14) propres à recevoir chacun un tel substrat (10), dispositif du genre mettant en oeuvre un échantillon d'essai (16), qui est porté par le support collectif (12), et un détecteur (18), qui est destiné à mesurer la déformation dont est l'objet cet échantillon d'essai (16), caractérisé en ce que l'échantillon d'essai (16) est porté par un support individuel (20), qui est susceptible d'être reçu dans un des emplacements (14) du support collectif (12) en substitution à un substrat (10), et qui porte, en outre, conjointement, la portion introductive (21), au moins, du détecteur (18).

3. Dispositif suivant la revendication 2, caractérisé en ce que le détecteur (18) est un détecteur optique.

4. Dispositif suivant la revendication 3, caractérisé en ce que le support individuel (20) porte également la portion terminale (34), au moins, d'une source de lumière (35) qui dirige un faisceau lumineux sur l'échantillon d'essai (16), et le détecteur (18) optique est un détecteur de déplacement sur la portion introductive (21) duquel est renvoyé le faisceau lumineux réfléchi par l'échantillon d'essai (16).

5. Dispositif suivant la revendication 4, caractérisé en ce que, la partie d'émission (38) de la source de lumière (35) étant située à l'extérieur de l'enceinte de traitement (11), sa portion terminale (34) portée par le support individuel (20) est formée par l'extrémité d'une partie de conduction (39) reliant audit support individuel (20) ladite partie d'émission (38).

6. Dispositif suivant la revendication 4, caractérisé en ce que la source lumineuse (35) se réduit à sa portion terminale (34), celle-ci étant reliée par des conducteurs électriques (70) à une alimentation électrique (71) située à l'extérieur de l'enceinte de traitement (11).

7. Dispositif suivant la revendication 2, caractérisé en ce que le détecteur (18) est un détecteur électrique.

8. Dispositif suivant la revendication 7, caractérisé en ce que la portion introductive (21) du détecteur (18) électrique est une électrode formant avec l'échantillon d'essai (16) une capacité différentielle, et ledit détecteur (18) électrique comporte en outre un capacimètre (52) établi entre ladite électrode et l'échantillon d'essai (16).

9. Dispositif suivant la revendication 8, caractérisé en ce que l'électrode formant la portion introductive (21) du détecteur (18) électrique est montée réglable en position sur le support individuel (20), pour ajustement de la distance qui la sépare de l'échantillon d'essai (16).

10. Dispositif suivant la revendication 2, caractérisé en ce que le détecteur (18) est un détecteur mécanique.

11. Dispositif suivant la revendication 10, caractérisé en ce que la portion introductive (21) du détecteur (18) mécanique est une sonde formant palpeur, qui, sous la sollicitation de moyens élastiques (58), porte sur l'échantillon d'essai (16), et ledit détecteur (18) mécanique comporte en outre une tête de mesure (59) sensible à la force suivant laquelle ladite portion introductive (21) s'applique audit échantillon d'essai (16).

12. Dispositif suivant la revendication 11, caractérisé en ce que ladite portion introductive (21) est disposée en bout d'une lame élastiquement déformable portée par la tête de mesure (59).

13. Dispositif suivant la revendication 12, caractérisé en ce que la tête de mesure (59) du détecteur (18) mécanique est montée réglable en position sur le support individuel (20), pour ajustement de la force suivant laquelle la portion introductive (21) s'applique initialement à l'échantillon d'essai (16).

14. Dispositif suivant l'une quelconque des revendications 2 à 13, caractérisé en ce que la portion introductive (21), au moins, du détecteur (18) est portée par le support individuel (20) par l'intermédiaire d'une platine (32) formant une table XY.

15. Dispositif suivant l'une quelconque des revendications 2 à 13, caractérisé en ce que, situé à l'intérieur de l'enceinte de traitement (11), le détecteur (18) est en totalité porté par le support individuel (20).

16. Dispositif suivant l'une quelconque des revendications 2 à 15, caractérisé en ce que l'échantillon d'essai (16) est une lame portée par le support individuel (20) en étant encastrée à l'une, (25), de ses extrémités et libre à l'autre, (26), de celles-ci.

17. Dispositif suivant l'une quelconque des revendications 2 à 15, caractérisé en ce que l'échantillon d'essai (16) est un disque portant par simple gravité à sa périphérie sur un épaulement (62) du support individuel (20).

18. Dispositif suivant l'une quelconque des revendications 2 à 17, caractérisé en ce que l'échantillon d'essai (16) intervient du côté de la surface inférieure (23) du support individuel (20).

19. Dispositif suivant la revendication 2, caractérisé en ce que le support individuel (20) porte la totalité du détecteur (18), et il est prévu, entre ledit détecteur (18) et un récepteur (72) disposé à l'extérieur de l'enceinte de traitement (11) une chaîne de transmission radio (73).

20. Dispositif suivant la revendication 19, caractérisé en ce que la chaîne de transmission radio (73) comporte un émetteur (74), qui est porté par le support collectif (12), et auquel le détecteur (18) est relié par des conducteurs électriques (75), une antenne d'émission (76) qui est elle aussi portée par le support collectif (12) et à laquelle l'émetteur (74) est relié par des conducteurs électriques (77), et une antenne de réception (78), qui est portée par l'enceinte de traitement (11), et qui, par des conducteurs électriques (79) traversant à étanchéité cette enceinte de traitement (11), est reliée au récepteur (72).

21. Dispositif suivant la revendication 19, caractérisé en ce que, le support collectif (12) étant monté rotatif dans l'enceinte de traitement (11), l'antenne d'émission (76) est un fil électrique s'étendant circulairement autour de l'axe de rotation (A) correspondant, suivant un parallèle du support collectif (12), et l'antenne de réception (78) est disposée à l'aplomb de ce parallèle.

22. Dispositif suivant l'une quelconque des revendications 19 à 21, caractérisé en ce qu'il est prévu, en amont de la chaîne de transmission radio (73) une unité de traitement (80) apte à convertir en tension le ou les micro-courants en provenance du détecteur (18).

23. Dispositif suivant la revendication 22, caractérisé en ce que l'unité de traitement (80) et l'émetteur (74) sont disposés dans un même boîtier étanche (82) porté par le support collectif (12).

24. Dispositif suivant la revendication 23, caractérisé en ce que le boîtier étanche (82) contient également les batteries (83) nécessaires à l'alimentation de l'ensemble.

## Patentansprüche

1. Verfahren zur in situ Messung der Dehnungen bzw. Beanspruchungen, die sich im Inneren einer dünnen Schicht während ihrer Abscheidung auf einem Substrat (10) in einem Bearbeitungs- bzw. Formgebungsbehälter (11) entwickeln, in welchem ein gemeinsamer Support bzw. Träger (12) angeordnet ist, der eine Vielzahl von Anordnungsplätzen bzw. Stellen (14) aufweist, die geeignet sind, jeweils ein derartiges Substrat (10) aufzunehmen, gemäß welchem Verfahren ein Probemaß bzw. -muster (16), welches durch den gemeinsamen Support bzw. Träger (12) getragen ist, und ein Detektor (18) eingesetzt werden, welcher dazu bestimmt ist, die Deformation, welcher dieses Probemaß (16) ausgesetzt ist, zu messen, dadurch gekennzeichnet, daß das Probemaß (16) an einem einzelnen Support (20) angeordnet wird, welcher fähig ist, auf einem der Anordnungsplätze (14) des gemeinsamen Supports bzw. Trägers (12) anstelle eines Substrats (10) aufgenommen zu werden und welcher darüber hinaus gleichzeitig wenigstens das Eingangs- bzw. Eingabeteil (21) des Detektors (18) trägt.

2. Vorrichtung zur in situ Messung der Dehnungen bzw. Beanspruchungen, die sich im Inneren einer dünnen Schicht während ihrer Abscheidung auf einem Substrat (10) in einem Bearbeitungs- bzw. Formgebungsbehälter (11) entwickeln, in welchem ein gemeinsamer Support bzw. Träger (12) angeordnet ist, der eine Vielzahl von Anordnungsplätzen bzw. Stellen (14) aufweist, die geeignet sind, jeweils ein derartiges Substrat (10) aufzunehmen, wobei in der Vorrichtung ein Probemaß bzw. -muster (16), welches durch den gemeinsamen Support bzw. Träger (12) getragen ist, und ein Detektor (18) eingesetzt sind, welcher dazu bestimmt ist, die Deformation, welcher dieses Probemaß (16) ausgesetzt ist, zu messen, dadurch gekennzeichnet, daß das Probemaß (16) durch einen einzelnen Support (20) getragen ist, welcher fähig ist, in einem der Anordnungsplätze (14) des gemeinsamen Supports bzw. Trägers (12) anstelle eines Substrats (10) aufgenommen zu werden und welcher darüberhinaus gleichzeitig wenigstens das Eingangs- bzw. Eingabeteil (21) des Detektors (18) trägt.

3. Vorrichtung nach Anspruch 2, dadurch gekennzeichnet, daß der Detektor (18) ein optischer Detektor ist.

4. Vorrichtung nach Anspruch 3, dadurch gekennzeichnet, daß der einzelne Support (20) auch wenigstens den Anschluß- bzw. Endbereich (34) einer Lichtquelle (35) trägt, welche einen Lichtstrahl auf das Probemaß (16) richtet, und daß der optische Detektor (18) ein Verschiebungsdetektor ist, auf dessen Eingangs- bzw. Eingabeteil (21) der durch das Probemaß (16) reflektierte Lichtstrahl zurückgestrahlt bzw. reflektiert ist.

5. Vorrichtung nach Anspruch 4, dadurch gekennzeichnet, daß das Emissionsteil (38) der Lichtquelle (35) an der Außenseite des Bearbeitungs- bzw. Formgebungsbehälter (11) angeordnet ist, und daß sein durch den individuellen bzw. einzelnen Support (20) getragener Anschluß- bzw. Endbereich (34) durch das Ende eines leitenden Teils (39) gebildet ist, welcher das Emissionsteil mit dem einzelnen Support (20) (38) verbindet.

6. Vorrichtung nach Anspruch 4, dadurch gekennzeichnet, daß die Lichtquelle (35) sich in ihrem Anschluß- bzw. Endbereich (34) verkleinert bzw. verjüngt, welcher durch elektrische Leiter (70) mit einer elektrischen Versorgung (71), die an der Außenseite des Bearbeitungsbehälters (11) angeordnet ist, verbunden ist.

7. Vorrichtung nach Anspruch 2, dadurch gekennzeichnet, daß der Detektor (18) ein elektrischer Detektor ist.

8. Vorrichtung nach Anspruch 7, dadurch gekennzeichnet, daß das Eingangs- bzw. Eingabeteil (21) des elektrischen Detektors (18) eine Elektrode ist, die mit dem Probemaß (16) eine Kleinsignalkapazität bildet und daß der elektrische Detektor (18) darüberhinaus eine Kapazitätsmeßeinrichtung (52) umfaßt, die zwischen der Elektrode und dem Probemaß (16) angeordnet ist.

9. Vorrichtung nach Anspruch 8, dadurch gekennzeichnet, daß die das Eingangs- bzw. Eingabeteil (21) des elektrischen Detektors (18) bildende Elektrode in ihrer Position auf dem individuellen bzw. einzelnen Support (20) für die Einstellung des Abstandes, welcher sie von dem Probemaß (16) trennt, verstellbar angeordnet bzw. festgelegt ist.

10. Vorrichtung nach Anspruch 2, dadurch gekennzeichnet, daß der Detektor (18) ein mechanischer Detektor ist.

11. Vorrichtung nach Anspruch 10, dadurch gekennzeichnet, daß das Eingangs- bzw. Eingabeteil (21) des mechanischen Detektors (18) eine einen Fühler bzw. Abtaststift bildende Sonde ist, welche unter der Belastung von elastischen Elementen (58) auf dem Probemaß (16) aufliegt, und daß der mechanische Detektor (18) darüberhinaus einen Meßkopf (59) umfaßt, der für die Kraft, mit welcher das Eingangs- bzw. Eingabeteil (21) auf dem Probemaß (16) anliegt, empfindlich ist.

12. Vorrichtung nach Anspruch 11, dadurch gekennzeichnet, daß das Eingangs- bzw. Eingabeteil (21) am Ende einer elastisch deformierbaren Zunge bzw. Lamelle, die von dem Meßkopf (59) getragen ist, angeordnet ist.

13. Vorrichtung nach Anspruch 12, dadurch gekennzeichnet, daß der Meßkopf (59) des mechanischen Detektors (18) in seiner Position zur Einstellung der Kraft, mit welcher das Eingangs- bzw. Eingabeteil (21) zu Beginn auf das Probemaß (16) anliegt, auf dem individuellen bzw. einzelnen Support (20) verstellbar angeordnet bzw. festgelegt ist.

14. Vorrichtung nach einem der Ansprüche 2 bis 13, dadurch gekennzeichnet, daß wenigstens das Eingangs- bzw. Eingabeteil (21) des Detektors (18) von dem einzelnen Suport (20) unter Zwischenschaltung einer Trageplatte (32), die einen XY-Tisch ausbildet, getragen ist.

15. Vorrichtung nach einem der Ansprüche 2 bis 13, dadurch gekennzeichnet, daß der im Inneren des Bearbeitungs- bzw. Formgebungsbehälter (11) angeordnete Detektor (18) vollständig von dem einzelnen Support (20) getragen ist.

16. Vorrichtung nach einem der Ansprüche 2 bis 15, dadurch gekennzeichnet, daß das Probemaß (16) eine Zunge bzw. Lamelle ist, die von dem einzelnen Support (20) getragen ist, wobei sie an dem einen (25) ihrer Enden eingespannt ist und an dem anderen (26) derselben frei ist.

17. Vorrichtung nach einem der Ansprüche 2 bis 15, dadurch gekennzeichnet, daß das Probemaß (16) eine durch einfache Schwerkraft an ihrem Umfang auf einer Schulter (62) des einzelnen Supports (20) aufliegende Scheibe ist.

18. Vorrichtung nach einem der Ansprüche 2 bis 17, dadurch gekennzeichnet, daß das Probemaß (16) an der Seite der unteren Oberfläche (23) des einzelnen Supports (20) angeordnet ist.

19. Vorrichtung nach Anspruch 2, dadurch gekennzeichnet, daß der einzelne Support (20) die Gesamtheit des Detektors (18) trägt und daß zwischen dem Detektor (18) und einem Empfänger (72), der an der Außenseite des Bearbeitungs- bzw. Formgebungsbehälter (11) angeordnet ist, eine Radioübertragungskette (73) angeordnet ist.

20. Vorrichtung nach Anspruch 19, dadurch gekennzeichnet, daß die Radioübertragungskette (73) einen Emitter bzw. Sender (74), der von dem gemeinsamen Support bzw. Träger (12) getragen ist und mit welchem der Detektor (18) durch elektrische Leiter (75) verbunden ist, eine Sendeantenne (76), die ebenfalls von dem gemeinsamen Support (12) getragen ist und mit welcher der Emitter bzw. Sender (74) durch elektrische Leiter (77) verbunden ist, und eine Aufnahme- bzw. Empfangsantenne (78) umfaßt, die von dem Bearbeitungs- bzw. Formgebungsbehälter (11) getragen ist und die durch elektrische Leiter (79), die dichtend diesen Bearbeitungs- bzw. Formgebungsbehälter (11) durchqueren, mit dem Empfänger (72) verbunden ist.

21. Vorrichtung nach Anspruch 19, dadurch gekennzeichnet, daß der gemeinsame Support bzw. Träger (12) drehbar in dem Bearbeitungs- bzw. Formgebungsbehälter (11) angeordnet ist, daß die Sendeantenne (76) ein elektrischer Draht ist, der sich kreisförmig um die entsprechende Rotationsachse (A) entlang einer Parallelen zum gemeinsamen Support bzw. Träger (12) erstreckt, und daß die Empfangs- bzw. Aufnahmeantenne (78) senkrecht zu dieser Parallelen angeordnet ist.

22. Vorrichtung nach einem der Ansprüche 19 bis 21, dadurch gekennzeichnet, daß stromaufwärts von der Radioübertragungskette (73) eine Bearbeitungseinheit (80) vorgesehen ist, die fähig bzw. geeignet ist, den oder die von dem Detektor (18) stammenden Mikroströme in Spannungen umzuwandeln.

23. Vorrichtung nach Anspruch 22, dadurch gekennzeichnet, daß die Bearbeitungseinheit (80) und der Emitter bzw. Sender (74) in einem gemeinsamen dichten Geäuse (82) angeordnet sind, welches durch den gemeinsamen Träger bzw. Support (12) getragen ist.

24. Vorrichtung nach Anspruch 23, dadurch gekennzeichnet, daß der dichte Behälter (82) auch die für die Speisung der Gesamtheit erforderlichen Batterien (83) enthält.

## Claims

1. A process for the in-situ measurement of the stresses which develop within a thin layer upon deposit thereof on a substrate (10) in a treatment chamber (11) in which there is operatively disposed a collective support (12) having a plurality of locations (14) each suitable for receiving such a substrate (10), in which process there is used a test sample (16) which is carried by the collective support (12) and a detector (18) which is intended to measure the deformation to which said test sample (16) is subjected. characterised in that the test sample (16) is disposed on an individual support (20) which is capable of being received in one of the locations (14) of the collective support (12) as a substitute for a substrate (10) and which also carries jointly the introductory portion (21) at least of the detector (18).

2. Apparatus for the in-situ measurement of the stresses which develop within a thin layer upon deposit thereof on a substrate (10) in a treatment chamber (11) in which there is operatively disposed a collective support (12) having a plurality of locations (14) each suitable for receiving such a substrate (10), being an apparatus of the kind using a test sample (16) which is carried by the collective support (12) and a detector (18) which is intended to measure the deformation to which said test sample (16) is subjected, characterised in that the test sample (16) is carried by an individual support (20) which is capable of being received in one of the locations (14) of the collective support (12) as a substitute for a substrate (10) and which also carries jointly the introductory portion (21) at least of the detector (18).

3. Apparatus according to claim 2 characterised in that the detector (18) is an optical detector.

4. Apparatus according to claim 3 characterised in that the individual support (20) also carries the terminal portion (34) at least of a light source (35) which directs a light beam on to the test sample (16) and the optical detector (18) is a displacement detector, on to the introductory portion (21) of which is directed the light beam reflected by the test sample (16).

5. Apparatus according to claim 4 characterised in that, the emission part (38) of the light source (35) being disposed on the outside of the treatment chamber (11), its terminal portion (34) carried by the individual support (20) is formed by the end of a conduction part (39) connecting said emission part (38) to said individual support (20).

6. Apparatus according to claim 4 characterised in that the light source (35) is reduced to its terminal portion (34), the latter being connected by electrical conductors (70) to an electrical power supply (71) disposed outside the treatment chamber (11).

7. Apparatus according to claim 2 characterised in that the detector (18) is an electrical detector.

8. Apparatus according to claim 7 characterised in that the introductory portion (21) of the electrical detector (18) is an electrode which with the test sample (16) forms a differential capacitor, and said electrical detector (18) further comprises a faradmeter (52) disposed between said electrode and the test sample (16).

9. Apparatus according to claim 6 characterised in that the electrode forming the introductory portion (21) of the electrical detector is mounted adjustably in position on the individual support (20) for adjustment of the distance which separates it from the test sample (16).

10. Apparatus according to claim 2 characterised in that the detector (18) is a mechanical detector.

11. Apparatus according to claim 10 characterised in that the introductory portion (21) of the mechanical detector (18) is a probe forming a feeler means which bears against the test sample (16) under the force of resilient means (58) and said mechanical detector (18) further comprises a measuring head (59) which is responsive to the force with which said introductory portion (21) is applied to said test sample (16).

12. Apparatus according to claim 11 characterised in that said introductory portion (21) is disposed at the end of a resiliently deformable blade carried by the measuring head (59).

13. Apparatus according to claim 12 characterised in that the measuring head (59) of the mechanical detector (18) is mounted adjustably in position on the individual support (20) for adjustment of the force with which the introductory portion (21) is initially applied to the test sample (16).

14. Apparatus according to any one of claims 2 to 13 characterised in that the introductory portion (21) at least of the detector (14) is carried by the individual support (20) by way of a plate (32) forming an XY-table.

15. Apparatus according to any one of claims 2 to 13 characterised in that disposed in the interior of the treatment chamber (11) the detector (18) is wholly carried by the individual support (20).

16. Apparatus according to any one of claims 2 to 15 characterised in that the test sample (16) is a blade carried by the individual support (20), being fixed at one (25) of its ends and free at the other (26) thereof.

17. Apparatus according to any one of claims 2 to 15 characterised in that the test sample (16) is a disc which bears simply by the force of gravity at its periphery against a shoulder (62) of the individual support (20).

18. Apparatus according to any one of claims 2 to 17 characterised in that the test sample (16) is operatively disposed at the side of the lower surface (23) of the individual support (20).

19. Apparatus according to claim 2 characterised in that the individual support (20) carries the whole of the detector (18) and a radio transmission link (73) is provided between said detector (18) and a receiver (72) disposed outside the treatment chamber (11).

20. Apparatus according to claim 19 characterised in that the radio transmission link (73) comprises a transmitter (74) which is carried by the collective support (12) and to which the detector (18) is connected by electrical conductors (75), a transmission antenna (76) which is also carried by the collective support (12) and to which the transmitter (74) is connected by electrical conductors (77), and a receiving antenna (78) which is carried by the treatment chamber (11) and which is connected to the receiver (72) by electrical conductors (79) passing in sealed relationship through said treatment chamber (11).

21. Apparatus according to claim 19 characterised in that, the collective support (12) being mounted rotatably in the treatment chamber (11), the transmission antenna (76) is an electrical wire extending in a circular configuration around the corresponding axis of rotation (A) along a parallel of the collective support (12), and the receiving antenna (78) is disposed in vertical alignment with said parallel.

22. Apparatus according to any one of claims 19 to 21 characterised in that provided upstream of the radio transmission link (73) is a treatment unit (80) for converting into voltage the micro-current or micro-currents from the detector (18).

23. Apparatus according to claim 22 characterised in that the treatment unit (80) and the transmitter (74) are disposed in the same sealed casing (82) carried by the collective support (12).

24. Apparatus according to claim 23 characterised in that the sealed casing (82) also contains the batteries (83) necessary for the power supply for the assembly.
